# EUROPEAN PATENT APPLICATION

(11) **EP 3 258 760 A1**
(43) Date of publication of application: **20.12.2017**
(21) Application number: 16182569.0
(22) Date of filing: 03.08.2016
(51) Int. Cl.: H05K 9/00

(54) **ELECTROMAGNETIC INTEREFERENCE SHIELDING CONFIGURATION OF ELECTRONIC DEVICE**

(30) Priority: 14.06.2016 TW 105118492
(71) Applicant: Delta Electronics, Inc., Taoyuan County 32063 (TW)
(72) Inventor: LU, Chao-Hsien, 32063 Chungli Industrial Zone, Taoyuan City (TW); HSIEH, Ming-Chieh, 32063 Chungli Industrial Zone, Taoyuan City (TW); LIN, Xin-Hung, 32063 Chungli Industrial Zone, Taoyuan City (TW)
(74) Representative: 2K Patentanwälte Blasberg Kewitz & Reichel

(57) **Abstract**

An electromagnetic interference shielding configuration of an electronic device (1, 1a) includes a housing (10, 10a), a connecting circuit board (20, 20a), at least one EMI filter (30, 30a), and a shielding component (40, 40a). The housing (10, 10a) has an accommodating space (100, 100a) and a shielding space (101, 101a). A mainboard (12, 12a) is disposed in the accommodating space (100, 100a), and a connecting circuit board (20, 20a) is disposed in the shielding space (101, 101a) and electrically conducted to the mainboard (12, 12a). The at least one EMI filter (30, 30a) is disposed on the connecting circuit board (20, 20a) and electrically conducted to the mainboard (12, 12a) through the connecting circuit board (20, 20a). The shielding component (40, 40a) combines with the housing (10, 10a) and covers the EMI filter (30, 30a). Thus the EMI filter (30, 30a) will not have electromagnetic interferences with external electronic components and provide a stable operation of the electronic device (1, 1a).

## Description

### BACKGROUND OF THE INVENTION

### FIELD OF THE INVENTION

The present invention generally relates to an electromagnetic interference shielding configuration and, in particular to an electromagnetic interference shielding configuration that is provided separately in an electronic device.

### DESCRIPTION OF PRIOR ART

Generally speaking, electronic components of motors or electronic devices will generate electromagnetic noises during operating. Moreover, electromagnetic noises outside the device would cause abnormal operation to the device via radiation or conduction.

In tradition, in order to prevent the radiation or conduction noises from affecting the surrounding electricity usage, the solution is to add a filter circuit on a mainboard for filtering the electromagnetic noises. However, the filter circuit might be affected by the electromagnetic interference of an external device that causes instability problems of the filter. Besides, disposing a filter circuit on a mainboard will take up space on the mainboard and further affect arrangement of other electronic components.

In view of the above drawbacks, the Inventor proposes the present invention based on his expert knowledge and elaborate researches in order to solve the problems of prior art.

### SUMMARY OF THE INVENTION

Accordingly, an object of the present invention is to provide an electromagnetic interference shielding configuration of an electronic device for an EMI filter will not have electromagnetic interferences with external electronic components and provide a stable operation of the electronic device.

Accordingly, another object of the present invention is to provide an electromagnetic interference shielding configuration of an electronic device, in which an EMI filter is disposed on another circuit board; therefore, the deposition of the EMI filter will not take up space on the mainboard, and the depositions of other electronic components can be arranged easily.

In order to achieve the object mentioned above, the present invention provides an electromagnetic interference shielding configuration of electronic device comprising a housing, a connecting circuit board, at least one EMI filter and a shielding component. The housing has an accommodating space and a shielding space. The connecting circuit board is disposed in the shielding space and electrically conducted to the mainboard through the connecting circuit board. The EMI filter is disposed on the connecting circuit board and electrically conducted to the mainboard through the connecting circuit board. The shielding component combines with the housing and covers the shielding space.

Comparing to the prior art, the electromagnetic interference shielding configuration of electronic device of the present invention is formed with an independent room in the shielding space. The shielding space is disposed for placing the EMI filter and its connecting circuit board individually, and then a shielding component covers the shielding space. Therefore, a better shielding effect is provided for the EMI filter in the shielding space, and then the EMI filter will not be affected by external electromagnetic interference during operation so that a normal operation will be performed. Moreover, because the EMI filter of the present invention is disposed in another circuit board, the deposition of the EMI filter will not take up space on the mainboard, and the depositions of other electronic components can be arranged easily.

### BRIEF DESCRIPTION OF DRAWING

The features of the invention believed to be novel are set forth with particularity in the appended claims. The invention itself, however, may be best understood by reference to the following detailed description of the invention, which describes a number of exemplary embodiments of the invention, taken in conjunction with the accompanying drawings, in which:
FIG. 1 is a perspective schematic view of an electromagnetic interference shielding configuration of electronic device of the present invention;
FIG. 2 is a partial perspective exploded schematic view of an electromagnetic interference shielding configuration of electronic device of the present invention;
FIG. 3 is a top view of an electromagnetic interference shielding configuration of electronic device of the present invention;
FIG. 4 is a perspective schematic view of another embodiment of an electromagnetic interference shielding configuration of electronic device of the present invention;
FIG. 5 is a partial top view of another embodiment of an electromagnetic interference shielding configuration of electronic device of the present invention.

### DETAILED DESCRIPTION OF THE PREFERRED EMBODIMENTS

In cooperation with attached drawings, the technical contents and detailed description of the invention are described thereinafter according to a number of preferable embodiments, being not used to limit its executing scope. Any equivalent variation and modification made according to appended claims is all covered by the claims claimed by the present invention.

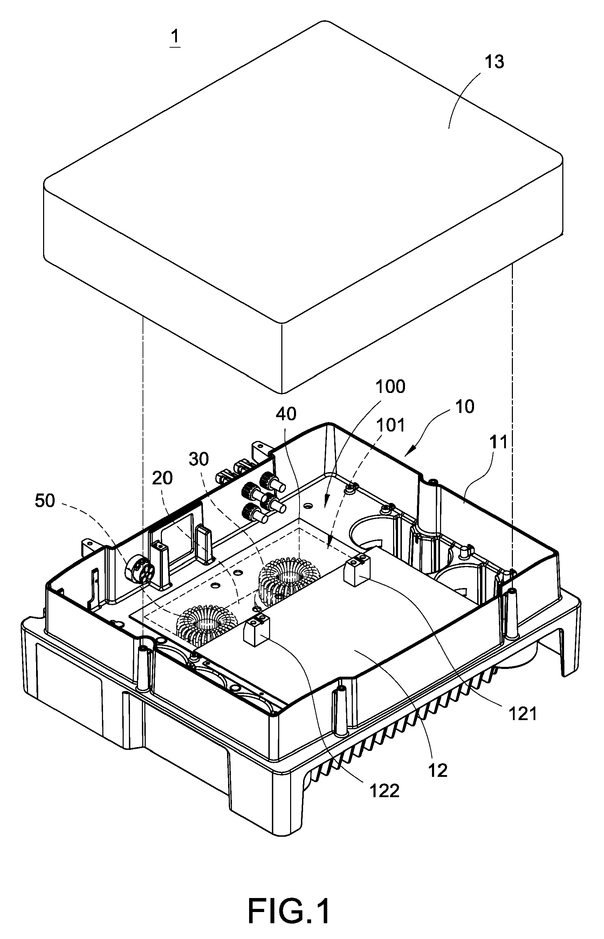

Please refer to FIG. 1 to FIG. 3, which depict a perspective schematic view, a partial perspective exploded schematic view and a top view of an electromagnetic interference shielding configuration of an electronic device of the present invention. An electromagnetic interference shielding configuration of an electronic device of the present invention includes a housing 10, a connecting circuit board 20, at least one EMI filter 30 and a shielding component 40. The EMI filter 30 is disposed on the connecting circuit board 20. The connecting circuit board 20 is installed in the housing 10. The shielding component 40 covers the EMI filter 30 for providing an electromagnetic interference shielding configuration of an electronic device 1.

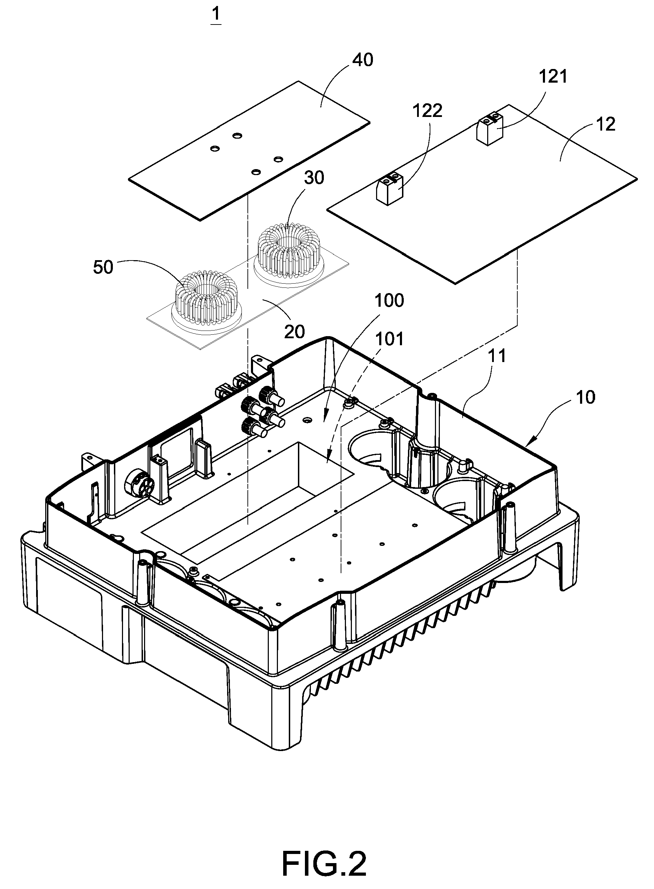

As shown in FIG. 1, the housing 10, preferably, is a metal shell. The housing 10 includes a plurality of plates 11, and the plates 11 are enclosed to form an accommodating space 100 and a shielding space 101; a mainboard 12 is disposed in the accommodating space 100. Please refer to FIG. 2, the shielding space 101 is concavely formed in the accommodating space 100, and the mainboard 12 is located at a side of the shielding space 101. In the present embodiment, the shielding space 101 is, but not limited to, a rectangular trough. The shielding space 101 can be provided in any shape that is suited for accommodating the connecting circuit board 20 and the EMI filter 30.

It is worth of notice that the method of forming the housing 10 is not limited. In real practice, the housing 10 is integrally formed such as casting etc.

The connecting circuit board 20 is used for disposing the EMI filter 30 separately. The connecting circuit board 20 is disposed in the shielding space 101 and electrically connected with the mainboard 12.

Moreover, the EMI filter 30 is a circuit configured by one or a plurality of electromagnetic (inductive) components combining with a plurality of capacitors. In an embodiment of the present invention, the EMI filter 30 is placed on the connecting board 20, and the EMI filter 30 is electrically conducted to the mainboard 12 through the connecting circuit board 20. More specifically, the EMI filter 30 is connected with the input port or the output port of the circuit; the EMI filter 30 is provided for preventing the conduction and radiation noises that have influence on the surrounding environment of electricity.

In an embodiment of the present invention, the mainboard 12 has an input port 121, and the EMI filter 30 is electrically conducted to the input port 121.

The shielding component 40 combines with the housing 10 and covers the EMI filter 30; preferably, the shielding component 40 covers the shielding space 101. In the present invention, the shielding component 40 is a metal sheet. The shielding component 40 covers the shielding space 101 and provides a shielding effect for the EMI filter 30 disposed in the shielding space 101. Therefore, the EMI filter 30 will not be affected by external electromagnetic interference during operation so that a normal operation will be performed.

In an embodiment of the present invention, the electromagnetic interference shielding configuration of the electronic device 1 further includes a second EMI filter 50. Furthermore, the second EMI filter 50 is disposed on the connecting circuit board 20 and located at a side of the EMI filter 30. The second EMI filter 50 is also electrically conducted to the mainboard 12 through the connecting circuit board 20. In more detail, the mainboard 12 has an output port 122, and the second EMI filter 50 is electrically conducted to the output port 122.

In an embodiment of the present invention, the housing 10 further includes a cover 13. The cover 13 seals the accommodating space 100 as to provide a shielding effect for the components in the accommodating space 100.

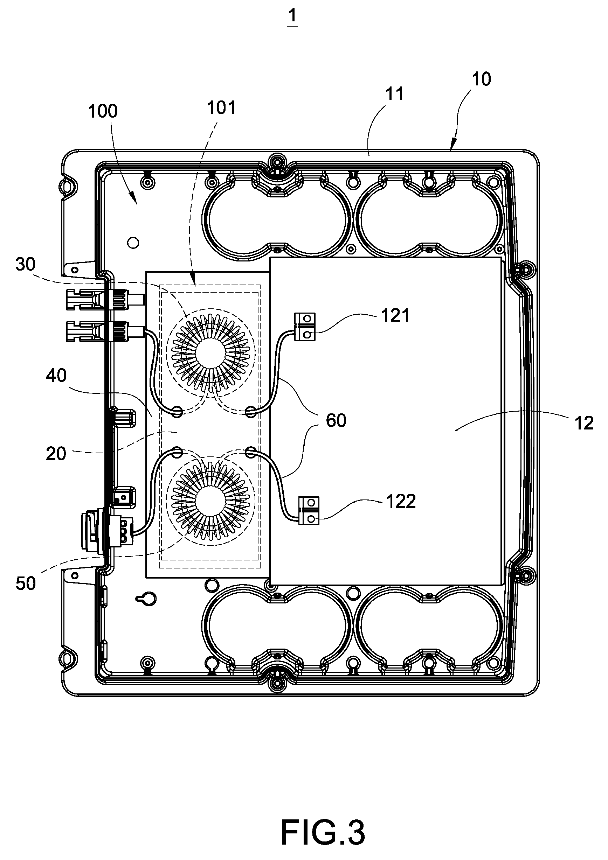

As shown in FIG. 3, the electromagnetic interference shielding configuration of the electronic device 1 further includes a plurality of conducting wires 60. The connecting circuit board 20 is electrically connected with the mainboard 12 through the conducting wires 60. In the present embodiment, the electronic device 1 is an inverter, and electronic components such as a PWM control unit and an oscillator are provided in the accommodating space 100.

It is worth of notice that, the electrical connection of the connecting circuit board 20 and the mainboard 12 is not limited to the conducting wires. In real practice, the electrical connection of the connecting circuit board 20 and the mainboard 12 can be achieved by connectors.

It is also worth of notice that, when the connecting circuit board 20, the EMI filter and the second EMI filter 50 are disposed in the shielding space 101, the shielding space 101 can be filled with sealant (not shown). The sealant can be a heatsink plaster that is used to dissipate heat of the connecting circuit board 20, the EMI filter 30 and the second EMI filter 50.

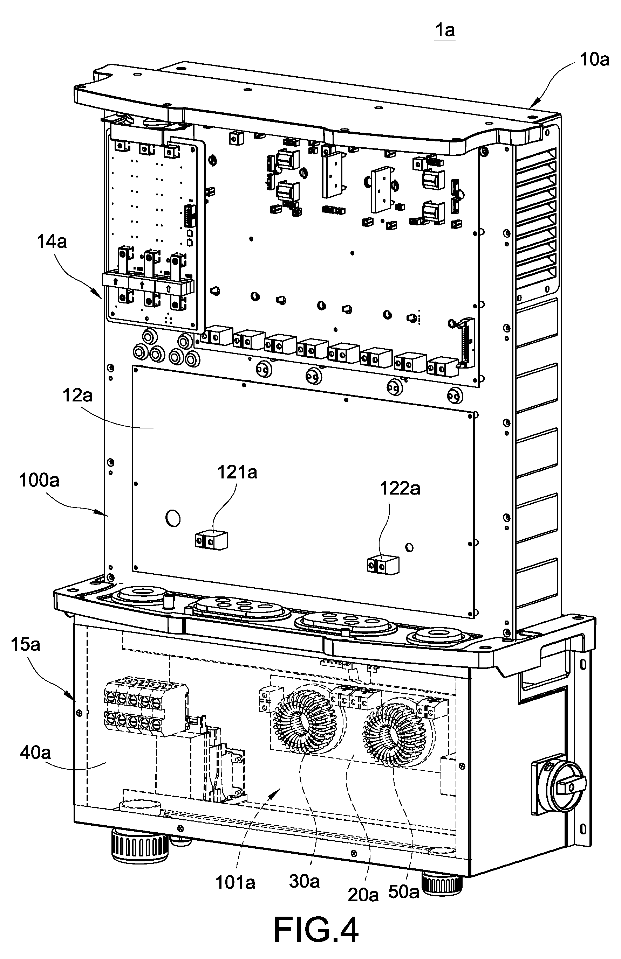

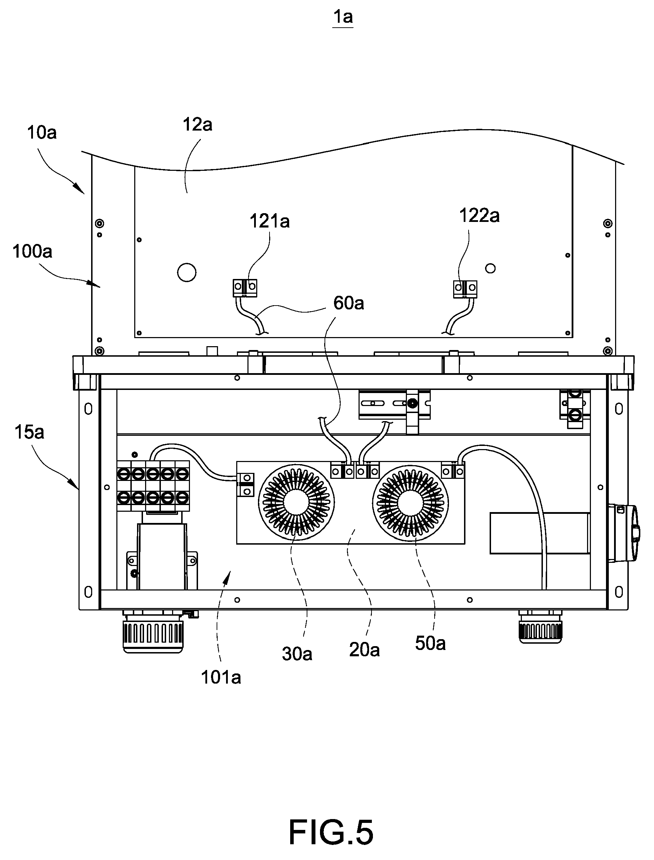

Please also refer to FIG. 4 and FIG. 5, which depict a perspective schematic view and a partial top view of another embodiment of an electromagnetic interference shielding configuration of electronic device 1a of the present invention. The present embodiment is substantially the same as the first embodiment. An electromagnetic interference shielding configuration of electronic device 1a includes a housing 10a, a connecting circuit board 20a, at least one EMI filter 30a, a shielding component 40a and a second EMI filter 50a. The housing 10a has an accommodating space 100a and a shielding space 10a. A mainboard 12a is disposed in the accommodating space 100a. The EMI filter 30a and the second EMI filter 50a are disposed on the connecting circuit board 20a, and the connecting circuit board 20a is installed in the shielding space 101a. The shielding component 40a covers the EMI filter 30a and the second EMI filter 50a for providing an electromagnetic interference shielding configuration of an electronic device 1a. A difference between the two embodiments is the disposition of the shielding space 101a.

In the present embodiment, the mainboard 12a has an input port 121 a and an output port 122a. Besides, the EMI filter 30a is electrically connected to the input port 121a, and the second EMI filter 50a is electrically connected to the output port 122a. In addition, the electromagnetic interference shielding configuration of electronic device 1a further includes a plurality of conducting wires 60a, and the connecting circuit board 20a is electrically connected with the mainboard 12a through the conducting wires 60a; that is, the EMI filter 30a and the second EMI filter 50a are electrically connected to the input port 121a and the output port 122a through the conducting wires 60a for providing an electromagnetic interference shielding effect.

In one embodiment of the present invention, the housing 10a includes a main region 14a and a routing region 15a separately located at a side of the main region 14a. Besides, the accommodating space 100a is located in the main region 14a, and the shielding space 101a is located in the routing region 15a. More specially, the routing region 15a and the main region 14a are provided isolatedly for having an electricity controlling space of the electronic device 1a. In this way, the configuration is good for maintenance and keeps better electrical characteristics.

In summary there is disclosed an electromagnetic interference shielding configuration of an electronic device 1, 1a includes a housing 10, 10a, a connecting circuit board 20, 20a, at least one EMI filter 30, 30a, and a shielding component 40, 40a. The housing 10, 10a has an accommodating space 100, 100a and a shielding space 101, 101a. A mainboard 12, 12a is disposed in the accommodating space 100, 100a, and a connecting circuit board 20, 20a is disposed in the shielding space 101, 101a and electrically conducted to the mainboard 12, 12a. The at least one EMI filter 30, 30a is disposed on the connecting circuit board 20, 20a and electrically conducted to the mainboard 12, 12a through the connecting circuit board 20, 20a. The shielding component 40, 40a combines with the housing 10, 10a and covers the EMI filter 30, 30a. Thus the EMI filter 30, 30a will not have electromagnetic interferences with external electronic components and provide a stable operation of the electronic device 1, 1a.

## Claims

1. An electromagnetic interference shielding configuration of electronic device (1, 1a), comprising:
a housing (10, 10a) having an accommodating space (100, 100a) and a shielding space (101, 101a), and a mainboard (12, 12a) being disposed in the accommodating space (100, 100a);
a connecting circuit board (20, 20a) disposed in the shielding space (101, 101a) and electrically conducted to the mainboard (12, 12a);
at least one EMI filter (30, 30a) disposed on the connecting circuit board (20, 20a) and electrically conducted to the mainboard (12, 12a) through the connecting circuit board (20, 20a); and
a shielding component (40, 40a) combining with the housing (10, 10a) and covering the EMI filter (30, 30a).

2. The electromagnetic interference shielding configuration of electronic device (1, 1a) according to claim 1, wherein the shielding space (101, 101a) is concavely formed in the accommodating space (100, 100a), and the mainboard (12, 12a) is located at a side of the shielding space (101, 101a).

3. The electromagnetic interference shielding configuration of electronic device (1, 1a) according to claim 1 or 2, wherein the shielding space (101, 101a) is filled with sealant.

4. The electromagnetic interference shielding configuration of electronic device (1, 1a) according to one of the preceding claims, wherein the shielding component (40, 40a) covers the shielding space (101, 101a).

5. The electromagnetic interference shielding configuration of electronic device (1, 1a) according to one of the preceding claims, wherein the mainboard (12, 12a) has an input port (121, 121a), and the EMI filter (30,30a) is electrically conducted to the input port (121, 121a).

6. The electromagnetic interference shielding configuration of electronic device (1, 1a) according to claim 5, further including a second EMI filter (50, 50a), wherein the second EMI filter (50, 50a) is disposed on the connecting circuit board (20, 20a) and electrically conducted to the mainboard (12, 12a) through the connecting circuit board (20, 20a).

7. The electromagnetic interference shielding configuration of electronic device (1, 1a) according to claim 6, wherein the mainboard (12, 12a) has an output port (122, 122a), and the second EMI filter (50, 50a) is electrically conducted to the output port (122, 122a).

8. The electromagnetic interference shielding configuration of electronic device (1, 1a) according to one of the preceding claims, further including a plurality of conducting wires (60, 60a), wherein the connecting circuit board (20, 20a) is electrically connected with the mainboard (12, 12a) through the conducting wires (60, 60a).

9. The electromagnetic interference shielding configuration of electronic device (1, 1a) according to one of the preceding claims, wherein the housing (10, 10a) is a metal shell, and the shielding component (40, 40a) is a metal sheet.

10. The electromagnetic interference shielding configuration of electronic device (1, 1a) according to one of the preceding claims, wherein the housing (10, 10a) includes a main region (14a) and a routing region (15a) separately located at a side of the main region (14a); the accommodating space (100, 100a) is located in the main region (14a), and the shielding space (101, 101a) is located in the routing region (15a).

11. The electromagnetic interference shielding configuration of electronic device (1, 1a) according to one of the preceding claims, wherein the electronic device (1, 1a) is an inverter; a PWM control unit and an oscillator are provided in the accommodating space (100, 100a).

12. The electromagnetic interference shielding configuration of electronic device (1, 1a) according to one of the preceding claims, wherein the shielding space (101, 101 a) is a rectangular trough.

13. The electromagnetic interference shielding configuration of electronic device (1, 1a) according to one of the preceding claims, wherein the housing (10, 10a) includes a plurality of plates (11), and the plates (11) are enclosed to form the accommodating space (100, 100a).

14. The electromagnetic interference shielding configuration of electronic device (1, 1a) according to one of the preceding claims, wherein the housing (10, 10a) is integrally formed.

15. The electromagnetic interference shielding configuration of electronic device (1, 1a) according to one of the preceding claims, wherein the housing (10, 10a) further includes a cover (13), and the cover (13) seals the accommodating space (100, 100a).
